# EUROPEAN PATENT APPLICATION

(11) **EP 3 062 591 A1**
(43) Date of publication of application: **31.08.2016**
(21) Application number: 16157735.8
(22) Date of filing: 26.02.2016
(51) Int. Cl.: H05K 5/02, G01D 11/24

(54) **LOCKING FOOT**

(30) Priority: 27.02.2015 US 201562126395 P; 22.02.2016 US 201615049338
(71) Applicant: Tektronix, Inc., Beaverton, Oregon 97077-0001 (US)
(72) Inventor: HOLLENBERG, Brian, Sherwood, OR 97140 (US); KREITZER, Robert, Tigard, OR 97224 (US); WALDO, Gary, Hillsboro, OR 97124 (US); GRIFFITH, Jonah, Seattle, WA 98117 (US); RANDALL, Jared, Seattle, WA 98107 (US)
(74) Representative: Clarke, Jeffrey David

(57) **Abstract**

A locking foldable foot includes a mounting plate, a first member, and a second member. The proximal end of the first member is attached to the mounting plate at a pivot. The second member is coupled to the first member and is structured to move parallel to the first member. The proximal end of the second member is structured to be capable of engaging the mounting plate to prevent rotation of the first and second members about the pivot. A test and measurement instrument includes the locking foldable foot. A method of preventing unintentional closure of a foldable foot on a test and measurement instrument includes locking the foldable foot in an open position in response to the weight of the test and measurement instrument being applied to the foldable foot.

## Description

### TECHNICAL FIELD

The present disclosure relates to test and measurement instruments, and more particularly to foot structures for test and measurement instruments.

### BACKGROUND

Test and measurement instruments, as well as other types of electronic devices and appliances, are often equipped with one or more types of foot structures on the bottom of the instrument, upon which the instrument may rest. Foot structures may include fixed parts, such as a pad that provides cushioning or a non-slip contact point for the device. Foot structures may also include moveable parts that operate to raise the device to a desired height, or to tilt the device to a desired angle, in order to achieve one or more advantages. For example, a device user may wish to tilt the device to a desired angle in order to improve ergonomics, reduce glare on the device's display, or improve accessibility of the device's user interface.

One common type of foot structure is referred to as a flip foot. A flip foot usually has a fixed pivot point at one end, and the foot rotates about the pivot point from a closed position to an open position. Typically, a pair of flip feet are placed on the bottom surface of a device, near its front edge. When the device sits on a relatively level horizontal surface and the feet are in the closed position, the front surface of the device will be in a generally vertical orientation. A user generally lifts up the front edge of the device and moves the flip feet to the open position. When in the open position, the flip feet prop up the device causing the front surface of the device to be at a set angle from vertical. This disclosure uses the terms "flip foot," "foldable foot," or simply "foot" interchangeably to refer to this type of foot structure.

### SUMMARY

A locking foldable foot, according to embodiments of the invention, includes a mounting plate, a first member having a proximal end and a distal end, and a second member having a proximal end and a distal end. The proximal end of the first member is attached to the mounting plate at a pivot. The second member is coupled to the first member and is structured to move parallel to the first member. The proximal end of the second member is structured to be capable of engaging the mounting plate to prevent rotation of the first and second members about the pivot.

In some embodiments, the locking function of the locking foldable foot is weight-activated. In these embodiments, in response to a force being applied to the distal end of the second member, the second member moves proximally toward the pivot so that the proximal end of the second member engages with the mounting plate. In some embodiments, the locking foldable foot also includes a spring coupled between the first and second member that acts to cause the second member to move distally away from the pivot so that the proximate end of the second member dis-engages the mounting plate when the force is removed from the distal end of the second member.

A test and measurement instrument, according to embodiments of the invention, includes a locking foldable foot, as described above, mounted to the test and measurement instrument. In some embodiments, when the weight of the test and measurement instrument is applied to the foot, the second member moves proximally toward the pivot so that the proximal end of the second member engages the mounting plate, and when the weight of the test and measurement instrument is removed from the foot, the second member moves distally away from the pivot so that the proximal end of the second member dis-engages the mounting plate.

A method of preventing unintentional closure of a foldable foot on a test and measurement instrument, according to embodiments of the invention, includes locking the foldable foot in an open position in response to the weight of the test and measurement instrument being applied to the foldable foot. In some embodiments, the method also includes unlocking the foldable foot from the open position in response to the weight of the test and measurement instrument being removed from the foldable foot.

### BRIEF DESCRIPTION OF THE DRAWINGS

FIG. 1A is a side elevation view of a test and measurement instrument having foldable feet in an open configuration, according to embodiments of the invention.
FIG. 1B is a bottom perspective view of the instrument of FIG. 1A showing a first set of the foldable feet in a folded or closed configuration and a second set of foldable feet in the open configuration, according to embodiments of the invention.
FIG. 2 is a cross-sectional view taken along lines 2-2 in FIG. 1B, showing the first set of foldable feet in a closed configuration in side elevation view within a foot-receiving recess shown in cross-section, according to embodiments of the invention.
FIG. 3 is a cross-sectional view taken along lines 3-3 in FIG. 1B, showing the second set of foldable feet in an open configuration in side elevation view protruding from the foot-receiving recess shown in cross-section, according to embodiments of the invention.
FIG. 4 is a cross-sectional view of a locking foldable foot in a semi-open position with the foot uncompressed, according to embodiments of the invention.
FIG. 5 is a cross-sectional view of the locking foldable foot similar to FIG. 4, showing the foot in a fully open position, with the foot uncompressed, according to embodiments of the invention.
FIG. 6 is a cross-sectional view of the locking foldable foot similar to FIG. 5, showing the foot fully open, with the foot compressed, according to embodiments of the invention.
FIG. 7 is a front elevation view of the locking foldable foot as seen along lines 4-4 of FIG. 3 showing the front foot in uncompressed condition, with interior details shown in dashed lines, according to embodiments of the invention.
FIG. 8 is a front elevation view of the locking foldable foot similar to FIG. 7, showing the front foot in compressed condition, with a portion cut away to show interior details, including a spring, in cross section, according to embodiments of the invention.

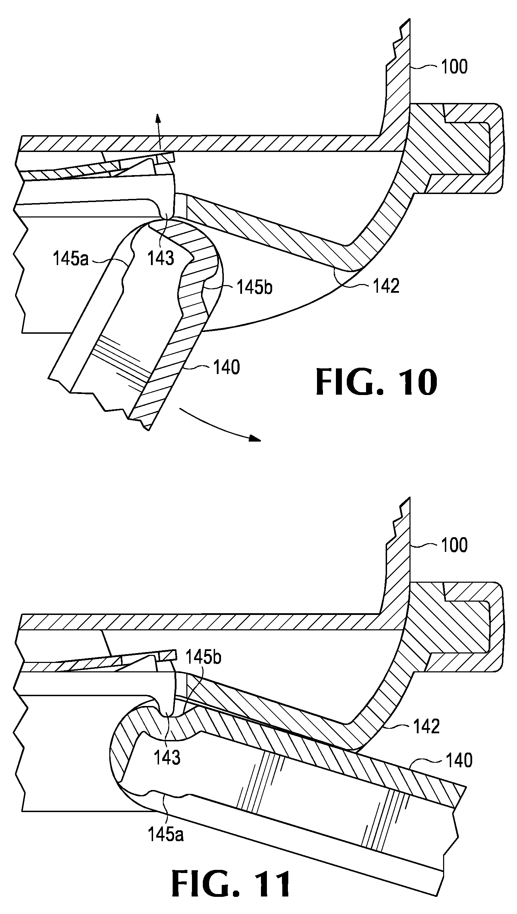

FIGS. 9, 10 and 11 are successive cross-sectional views of a portion of the rear foldable foot, progressing from the closed condition shown in FIG. 2, to the open condition shown in FIG. 3.

### DETAILED DESCRIPTION

A test and measurement instrument, or other device, typically has at least a pair of foldable feet located substantially at the two front corners of the bottom surface of the instrument. When the foldable feet are in a closed position, the bottom surface of the instrument is substantially level, parallel to the surface upon which the instrument is resting, such as a desk or workbench. In this position, the front face of the instrument is substantially perpendicular to the work surface. If the instrument user wants to change, for example, the viewing angle of a display on the front face of the instrument, the user typically lifts the front edge of the instrument up off the work surface to a height sufficient to allow the user to unfold each of the foldable feet into an open position, and then sets the instrument back down onto the open feet.

However, when in the open position, the foldable feet are susceptible to unexpectedly collapsing to the closed position, or partially collapsing, when the instrument is tipped or moved in certain ways. Specifically, the foldable feet are prone to unintentional closure when there is a sufficient back to front, lateral force applied to the instrument. Such forces can occur in normal use conditions of the instrument. For example, a user may need to tilt the instrument forward to verify or make a cable connection on the back of the instrument. When this forward tipping of the instrument exceeds a certain angle, the foldable feet are prone to collapse into their closed position. Or, a user may need to pull the instrument forward across the work surface toward herself to better reach the instrument's controls. Since foldable feet often have a non-slip coating at the end, or since the work surface itself may have non-slip properties, for example by being covered with an electrostatic discharge protective mat, dragging the instrument toward the user may cause the foldable feet to catch on the work surface and therefore collapse into their closed position.

The collapse of a foldable foot from its open position to its closed position can be sudden and unexpected and may cause the front edge of the instrument, which is often quite heavy, to crash onto the work surface. Such an unintentional collapse may cause damage to the instrument, damage to any accessories, such as a probe, that may be attached to the instrument, or, most importantly, may even cause an injury to the user. Therefore, what is needed is a way to prevent this kind of unintentional closure of a foldable foot.

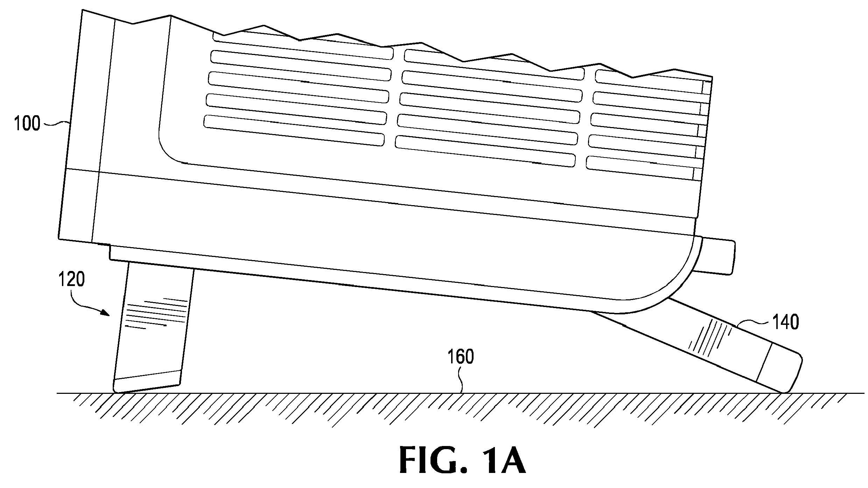

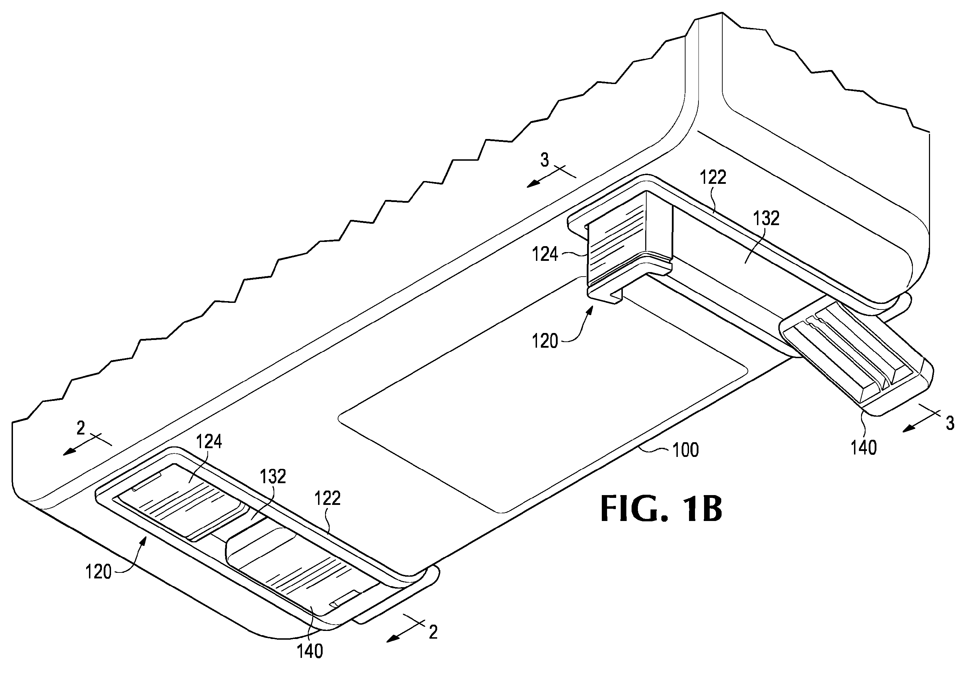

FIG. 1A is a side elevation view of a locking foldable foot 120, and a foldable foot 140, mounted to the bottom surface of a test and measurement instrument 100, according to embodiments of the invention. The foldable feet 120, 140 are in an open configuration and rest on a work surface 160. The foldable feet 120, 140 are shown mounted to the instrument 100 in what would be typical mounting locations: the locking foldable foot 120 is shown mounted near the front edge of the bottom surface of the test and measurement instrument 100, and the foldable foot 140 is mounted near the back edge of the bottom surface of the instrument 100. However, it should be understood that the foldable feet 120, 140 may be mounted at any location on any surface of the instrument 100, although some features of embodiments of the invention are more advantageous when the foldable feet 120, 140 are mounted in their typical locations substantially as shown. FIG. 1B is a bottom perspective view of the instrument 100 showing a first set of the foldable feet 120, 140 (front, rear) in a folded or closed configuration, and a second set of the foldable feet 120, 140 (front, rear) in the open configuration.

The locking foldable foot 120 includes a mounting plate 122. In preferred embodiments, the mounting plate 122 is structured to be mountable to an apparatus, such as the instrument 100. For example, the mounting plate 122 may have holes to allow the locking foldable foot 120 to be mounted to the instrument 100 with screws or other fasteners. Or, the mounting plate 122 may be structured to slide or snap into a slot in the chassis or housing of the instrument 100.

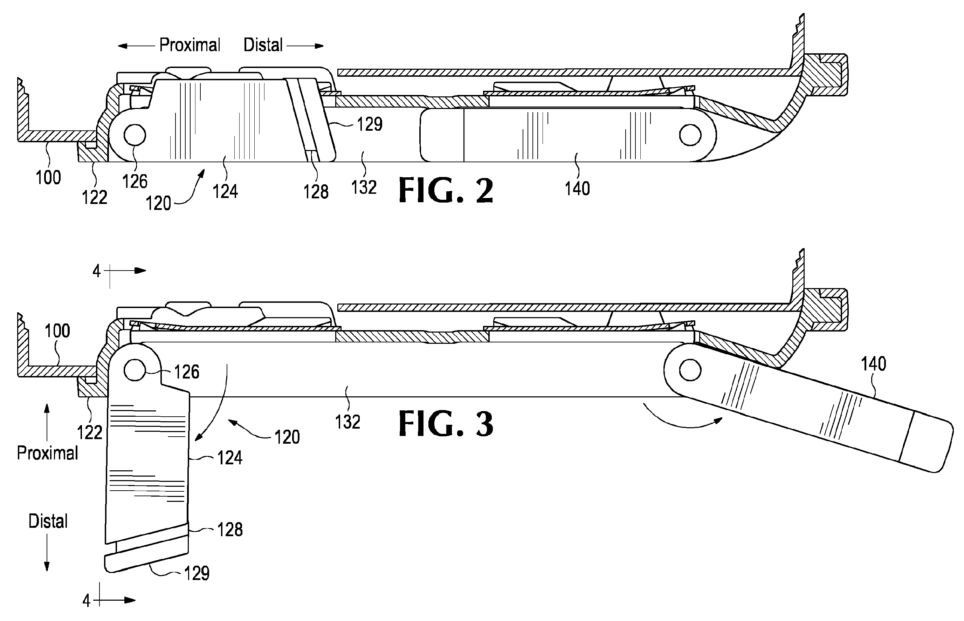

FIG. 2 is a cross-sectional view taken along lines 2-2 in FIG. 1B, showing the locking foldable foot 120 in a closed configuration in side elevation view according to embodiments of the invention. FIG. 3 is a cross-sectional view taken along lines 3-3 in FIG. 1B, showing the locking foldable foot 120 in an open configuration according to embodiments of the invention.

In addition to the mounting plate 122, the locking foldable foot 120 includes a first member 124 and a second member 128.

The first member 124 has a proximal end and a distal end. The proximal end of the first member 124 is attached to the mounting plate 122 at a pivot 126. In preferred embodiments, the first member 124 rotates between a closed position, as shown in FIG. 2, and an open position, as shown in FIG. 3. In preferred embodiments, when the first member 124 is in the closed position, the first member 124 fits into a foot-receiving recess 132 in the mounting plate 122.

FIGS. 1A, 1B, and 2-3 illustrate the rear foldable foot 140 as also being attached to the same mounting plate 122, and also folding into the same foot-receiving recess 132 in the mounting plate 122 when in the closed configuration. However, it should be understood that the foldable foot 140 is completely separable and independent from the locking foldable foot 120, and may instead be manufactured as its own assembly. Thus, the remainder of this disclosure will focus on details of the locking foldable foot 120.

In order to prevent the first member 124 from swinging freely open from the closed position, and in order to provide tactile feedback to a user, the locking foldable foot 120, according to some embodiments, includes a first detent for resisting rotation of the first member 124 when in the closed position, and a second detent for resisting rotation of the first member when in the open position. A "detent" is a device or mechanism for positioning and holding one mechanical part in relation to another-here, a mechanism for holding the first member 124 in relation to the mounting plate 122—so that the mechanism can be released by sufficient force applied to one of the parts.

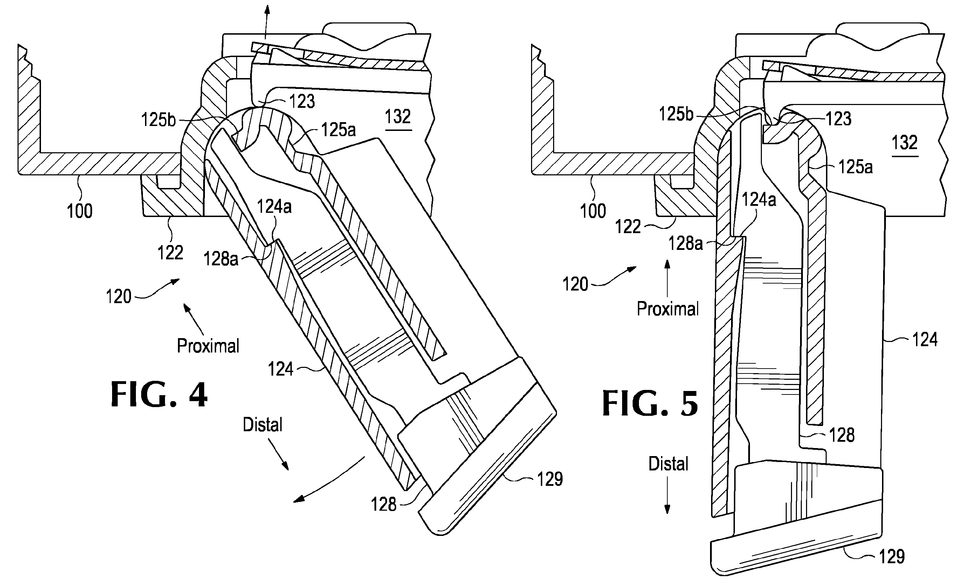

Referring to FIGS. 4-6, in some embodiments, the first detent is effected through the engagement of a tang 123 in the mounting plate 122 with a first recess 125a in the first member 124, and the second detent is effected through the engagement of the tang 123 with a second recess 125b in the first member 124. As the first member 124 rotates out of the closed position, the tang 123 bends up slightly to slide over the ridge in the first member 124 between the first and second recesses 125a, 125b, until the tang 123 settles into the second recess 125b when the first member 124 reaches the open position.

The second member 128 of the locking foldable foot 120, like the first member 124, also has a proximal end and a distal end. The second member 128 is coupled to the first member 124 and is structured to move parallel to the first member 124. For example, when the first member 124 rotates about the pivot 126 from the closed position to the open position, the second member 128 also rotates about the pivot 126, in parallel with the first member 124. The proximal end of the second member 126 is structured to be capable of engaging with the mounting plate 122 to prevent rotation of the first and second members 124, 128 about the pivot 126.

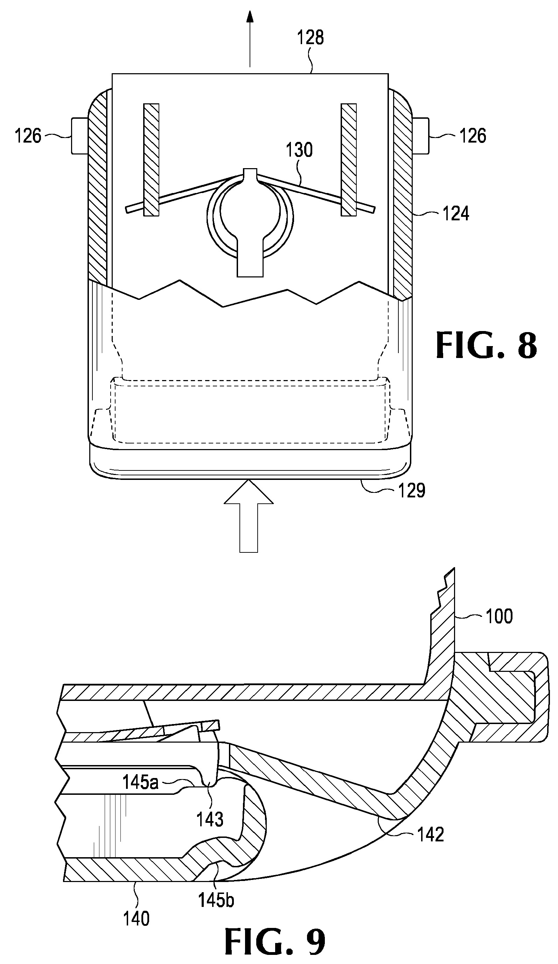

In preferred embodiments, the distal end of the second member 128 is structured to be capable of resting on the work surface 160. According to some embodiments, such as those shown in FIGS. 2-9, the distal end of the second member includes a non-slip pad 129.

The second member 128 is coupled to the first member 124 in such a way that the second member 128 is able to move, relative to the first member 124, along the proximal-distal axis. In preferred embodiments, such as those illustrated in FIGS. 4-9, the second member 128 is coupled to the first member 124 by being structured to telescope with the first member 124. In FIGS. 4-6, the second member 128 is illustrated as telescoping into the first member 124, but in alternative embodiments, the first member 124 may telescope into the second member 128. In still other embodiments, the second member 128 is coupled to the first member 124 by being structured to slide along a track in the first member 124.

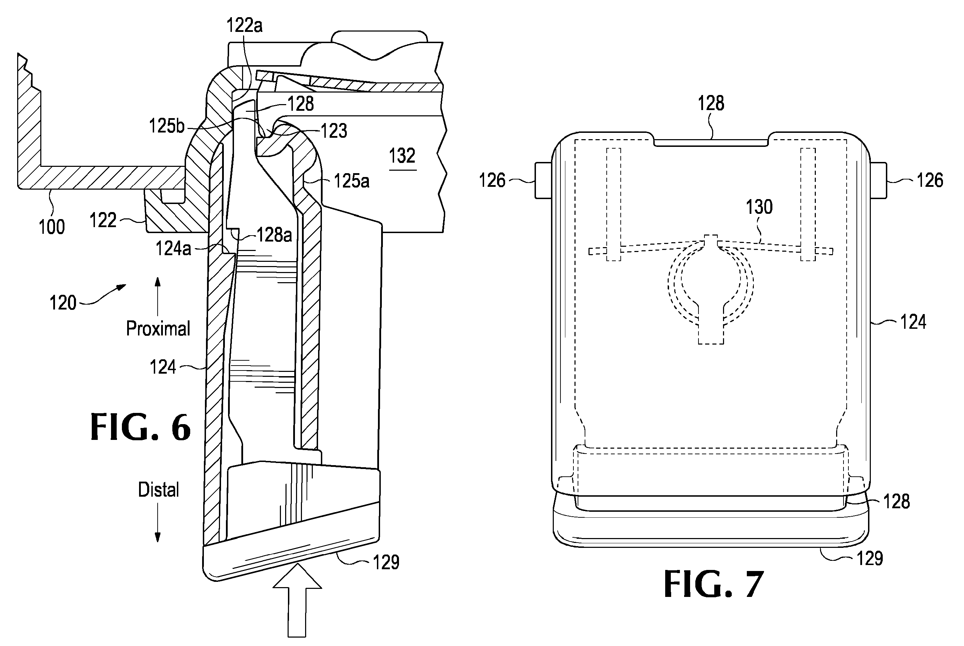

As shown in FIG. 6, since the second member 128 is capable of moving, relative to the first member 124, along the proximal-distal axis, in preferred embodiments, when the first member 124 is in the open position, in response to a force being applied to the distal end of the second member 128, the second member 128 moves proximally toward the pivot 126 so that the proximal end of the second member 128 engages the mounting plate 122, thereby locking the locking foldable foot 120 into the open position by preventing rotation of the first and second members 124, 128 about the pivot 126. In FIG. 6, the proximal end of the second member 128 is illustrated as engaging a surface 122a of the mounting plate 122. The tab-like structure at the proximal end of the second member 128 substantially fits into the cavity in the mounting plate 122 formed essentially by the surface 122a and the tang 123 in order to lock the first and second members 124, 128 into position and prevent the locking foldable foot 120 from collapsing back into the closed configuration.

FIGS. 2-8 illustrate the second member 128 as a single-piece of material, so that the force applied to the distal end of the second member 128 is directly translated to engagement of the proximal end of the second member 128 with the mounting plate. However, it should be understood that the second member 128 can comprise multiple pieces, such as one piece for the distal end, mechanically linked to another piece for the proximal end.

In preferred embodiments, the above-described locking mechanism of the locking foldable foot 120 is weight-activated. That is, because the locking foldable foot 120 will ordinarily be mounted to the bottom surface of the instrument 100, when a user lifts the front edge of the instrument 100 up, flips the locking foldable foot 120 into the open position, and then sets the instrument 100 back down onto the foot 120, the force applied to the distal end of the second member 128 is the weight of the instrument 100. Thus, the locking foldable foot 120 is automatically locked in place when the instrument 100 is resting on the foot 120 in the open configuration. This feature is highly advantageous since the user does not have to remember to engage a lock; rather, simply placing the instrument 100 back down onto the work surface 160 automatically engages the locking function.

In preferred embodiments, the above-described locking mechanism of the locking foldable foot 120 is also automatically dis-engaged when the weight of the instrument 100 is removed from the locking foldable foot 120. That is, when the force, such as the weight of the instrument 100, is removed from the distal end of the second member 128, the second member moves distally away from the pivot 126 so that the proximal end of the second member 128 dis-engages the mounting plate 122.

As shown in FIGS. 7-8, in some embodiments, the locking foldable foot 120 includes a spring 130 coupled between the first and second members 124, 128. The spring 130 acts to cause the second member 128 to move distally away from the pivot 126 when the force-e.g. the weight of the instrument 100-is removed from the distal end of the second member 128. The spring 130 is selected to ensure that the second member 128 will always snap back distally-thereby dis-engaging the locking function-when the weight of the instrument 100 is removed from the locking foldable foot 120. The user is then free to flip the locking foldable foot 120 back to the closed configuration.

According to some embodiments, in order to ensure that the second member 128 does not move too far distally, the first and second members 124, 128 are structured to limit the distal travel of the second member to an expanded position. For example, as shown in FIGS. 4-5, a ridge 124a on the first member 124, together with a corresponding ridge 128a on the second member 128 act to constrain the distal travel of the second member 128.

Examples provide a locking foldable foot comprising a mounting plate, a first member, having a proximal end and a distal end, the proximal end attached to the mounting plate at a pivot, and a second member, having a proximal end and a distal end, the second member coupled to the first member and structured to move parallel to the first member, in which the proximal end of the second member is structured to be capable of engaging the mounting plate to prevent rotation of the first and second members about the pivot.

In some examples the mounting plate is structured to be mountable to an apparatus.

In some examples the first member rotates between a closed position and an open position.

In some examples the first member fits into a recess in the mounting plate when in the closed position.

Some examples further comprise a first detent for resisting rotation of the first member when in the closed position, and a second detent for resisting rotation of the first member when in the open position.

In some examples the first and second detents each comprise a recess in the first member, and a tang in the mounting plate that engages the recess in the first member.

In some examples the second member is structured to slide along a track in the first member.

In some examples the second member is structured to telescope with the first member.

In some examples, in response to a force being applied to the distal end of the second member, the second member moves proximally toward the pivot so that the proximal end of the second member engages the mounting plate.

In some examples, in response to the force being removed from the distal end of the second member, the second member moves distally away from the pivot so that the proximal end of the second member dis-engages the mounting plate.

Some examples further comprise a spring coupled between the first and second members that acts to cause the second member to move distally away from the pivot when the force is removed from the distal end of the second member.

In some examples the first and second members are structured to limit the distal travel of the second member to an expanded position.

In some examples the distal end of the second member is structured to be capable of resting on a work surface.

In some examples the distal end of the second member comprises a non-slip pad.

Examples provide a test and measurement instrument comprising the locking foldable foot of some examples mounted to the test and measurement instrument.

In some examples, when the weight of the test and measurement instrument is applied to the locking foldable foot, the second member moves proximally toward the pivot so that the proximal end of the second member engages the mounting plate.

In some examples, when the weight of the test and measurement instrument is removed from the locking foldable foot, the second member moves distally away from the pivot so that the proximal end of the second member dis-engages the mounting plate.

Examples provide a method of preventing unintentional closure of a foldable foot on a test and measurement instrument, the method comprising locking the foldable foot in an open position in response to the weight of the test and measurement instrument being applied to the foldable foot.

Some examples further comprise unlocking the foldable foot from the open position in response to the weight of the test and measurement instrument being removed from the foldable foot.

Although specific embodiments of the invention have been illustrated and described for purposes of illustration, it will be understood that various modifications may be made without departing from the scope of the invention.

## Claims

1. A locking foldable foot comprising:
a mounting plate;
a first member, having a proximal end and a distal end, the proximal end attached to the mounting plate at a pivot; and
a second member, having a proximal end and a distal end, the second member coupled to the first member and structured to move parallel to the first member,
in which the proximal end of the second member is structured to be capable of engaging the mounting plate to prevent rotation of the first and second members about the pivot.

2. The locking foldable foot of claim 1 in which the mounting plate is structured to be mountable to an apparatus.

3. The locking foldable foot of claims 1 or 2 in which the first member rotates between a closed position and an open position.

4. The locking foldable foot of claim 3 in which the first member fits into a recess in the mounting plate when in the closed position.

5. The locking foldable foot of claim 3 or 4, further comprising:
a first detent for resisting rotation of the first member when in the closed position; and
a second detent for resisting rotation of the first member when in the open position.

6. The locking foldable foot of claim 5 in which the first and second detents each comprise:
a recess in the first member; and
a tang in the mounting plate that engages the recess in the first member.

7. The locking foldable foot of any previous claim in which:
the second member is structured to slide along a track in the first member; or
the second member is structured to telescope with the first member.

8. The locking foldable foot of any previous claim in which:
in response to a force being applied to the distal end of the second member, the second member moves proximally toward the pivot so that the proximal end of the second member engages the mounting plate; and/or
in response to the force being removed from the distal end of the second member, the second member moves distally away from the pivot so that the proximal end of the second member dis-engages the mounting plate.

9. The locking foldable foot of claim 8, further comprising a spring coupled between the first and second members that acts to cause the second member to move distally away from the pivot when the force is removed from the distal end of the second member; and optionally
in which the first and second members are structured to limit the distal travel of the second member to an expanded position.

10. The locking foldable foot of any previous claim in which the distal end of the second member is structured to be capable of resting on a work surface.

11. The locking foldable foot of claim 10 in which the distal end of the second member comprises a non-slip pad.

12. A test and measurement instrument comprising the locking foldable foot of any previous claim mounted to the test and measurement instrument.

13. The test and measurement instrument of claim 12 in which:
when the weight of the test and measurement instrument is applied to the locking foldable foot, the second member moves proximally toward the pivot so that the proximal end of the second member engages the mounting plate; and/or
when the weight of the test and measurement instrument is removed from the locking foldable foot, the second member moves distally away from the pivot so that the proximal end of the second member dis-engages the mounting plate.

14. A method of preventing unintentional closure of a foldable foot on a test and measurement instrument, the method comprising locking the foldable foot in an open position in response to the weight of the test and measurement instrument being applied to the foldable foot.

15. The method of claim 14, further comprising unlocking the foldable foot from the open position in response to the weight of the test and measurement instrument being removed from the foldable foot.
